# EUROPEAN PATENT APPLICATION

(11) **EP 4 641 630 A1**
(43) Date of publication of application: **29.10.2025**
(21) Application number: 24172336.0
(22) Date of filing: 25.04.2024
(51) Int. Cl.: H01L 23/367, H01L 23/373

(54) **HEAT SPREADING DEVICES AND TEMPERATURE-CONTROLLED SYSTEM**

(71) Applicant: Mehta, Mitul, 2930 Brasschaat (BE)
(72) Inventor: Mehta, Mitul, 2930 Brasschaat (BE)
(74) Representative: Renaudo, Adrien Hanouar

(57) **Abstract**

A heat spreading device (100) is disclosed. The heat spreading device (100) includes a diamond substrate (108) comprising one or more irregular and/or nonlinear microchannels (112) provided on a first side (114) of the diamond substrate (108). The heat spreading device (100) further includes one or more thermal vias (116) provided on a second side (118) of the diamond substrate (108) opposite to the one or more irregular and/or nonlinear microchannels (112). The one or more thermal vias (116) are configured to be connected to one or more heat generating sources (104) for transferring a heat generated from the one or more heat generating sources (104) to the diamond substrate (108).

## Description

### Technical Field

The present disclosure relates to a heat spreading device. More particularly, the present disclosure relates to a heat spreading device including a diamond substrate.

### Background

A heat spreading device, or a heat spreader is used in many heat generating sources such as electronic devices, integrated circuit dies, inductive charging coils, power amplifiers, laser diodes, high intensity discharge lamps, combustion heat exchangers, and the like such as air, liquid coolants, or heat sinks. The heat spreader is configured to dissipate heat from the heat generating source to an outside medium. The heat spreader typically dissipates heat by conduction, transferring heat from one solid to another. During operation of the heat generating source, a particular region of the heat generating source dissipates a maximum of heat while other regions dissipate lesser heat. Such uneven dissipation of heat leads to a highly non-uniform temperature distribution across the heat generating source and thus creates hot spots whose temperatures are significantly higher than the surrounding regions. During long usage of the electronic devices, the temperature of these hot spots may exceed recommended operating temperatures, thereby reducing life of the electronic devices and causing premature failures. Traditional heat spreading solutions, such as metal heat sinks and thermal interface materials, have limitations in terms of thermal conductivity and heat dissipation capabilities.

United States Patent No.: 10,434,235 discloses a heat sink made of a natural or polycrystalline diamond substrate with fins formed thereon. Diamond is grown to form a substrate and a laser is used to cut channels in the substrate to form the fins.

### Summary

In one aspect, the present disclosure relates to a heat spreading device comprising a diamond substrate. The diamond substrate further comprises one or more irregular and/or nonlinear microchannels provided on a first side of the diamond substrate and one or more thermal vias provided on a second side of the diamond substrate opposite to the one or more nonlinear microchannels. Each of the one or more thermal vias is configured to be connected to one or more heat generating sources for transferring a heat generated from the one or more heat generating sources to the diamond substrate.

In another aspect, the disclosure is directed towards a temperature-controlled system comprising one or more heat generating sources and one or more heat spreading devices coupled with the one or more heat generating sources. Each of the one or more heat spreading devices comprises a diamond substrate including one or more irregular or nonlinear microchannels provided on a first side of the substrate and one or more thermal vias provided on a second side of the substrate opposite to the one or more nonlinear microchannels. Each of the one or more thermal vias is configured to be connected to one or more heat generating sources for transferring a heat generated from the one or more heat generating sources to the diamond substrate.

### Brief Description of the Drawings

FIG. 1 is a perspective view of a heat spreading device, in accordance with some embodiments of the present disclosure;
FIG. 2A-2E are perspective views of the heat spreading device of FIG. 1 having different microchannel geometries, in accordance with some embodiments of the present disclosure;
FIG. 2F is a perspective view of a heat spreading device of FIG. 1 having inlet and outlet for circulating fluid, in accordance with some embodiments of the present disclosure;
FIG. 2G is a top view of a heat spreading device of FIG. 2B having ridges and grooves formed in the microchannels, in accordance with some embodiments of the present disclosure;
FIG. 2H is a side view of a heat spreading device of FIG. 1 having inlet and outlet for circulating fluid, in accordance with some embodiments of the present disclosure;
FIG. 3 is a side view of the heat spreading device of FIG. 1, in accordance with some embodiments of the present disclosure;
FIG. 4 is a side view of the heat spreading device of FIG. 1 connected with a heat generating source, in accordance with some embodiments of the present disclosure;
FIG. 5 is an exploded view of the heat spreading device and the heat generating source of FIG. 4, in accordance with an embodiment of the present disclosure; and
FIG. 6 is a side view of the heat spreading device including a lid, in accordance with an embodiment of the present disclosure.

### Detailed Description

Reference will now be made in detail to specific embodiments or features, examples of which are illustrated in the accompanying drawings. Wherever possible, the same reference numbers will be used throughout the drawings to refer to the same or the like parts.

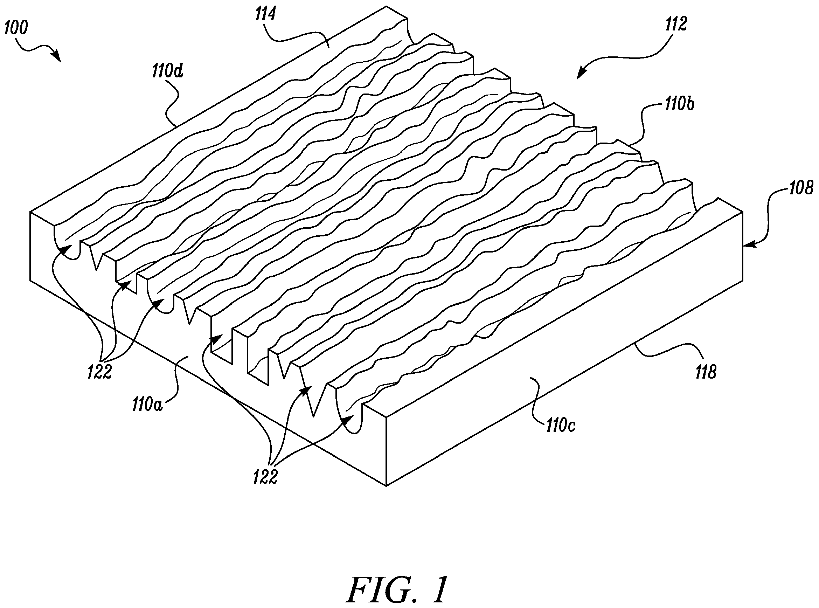

Referring to Fig. 1, an exemplary heat spreading device 100 is disclosed. The heat spreading device 100 is configured to dissipate heat from a heat generating source 104, which may be employed in diverse environments, including but not limited to, electronic devices, integrated circuit dies, inductive charging coils, power amplifiers, laser diodes, high intensity discharge lamps, combustion heat exchangers, vacuum electrode assemblies, turbine blades, steam generator components, mirror facets of solar concentrators, pharmaceutical reactors, microfluidic lab-on-chip devices, resistive memory elements, quantum computing qubits, biological imaging lasers, high speed reciprocating equipment, electrodes of a battery, a battery, an industrial electrolyzer system or microprocessors. In most environments, the heat spreading device 100 is configured to dissipate heat from the heat generating source 104 to an outside medium, such as a surrounding environment 102. The heat generating source 104 may represent one or more heats generating sources.

The heat spreading device 100 includes a diamond substrate 108. The diamond substrate 108 may be a single crystalline or textured polycrystalline diamond substrate which provides thermal conduction greater than 1200 W/mK (Watts per meter-Kelvin) at room temperature (e.g., 20 °C). The diamond substrate 108 may include a cuboidal shape. Other shapes and designs may be contemplated. The diamond substrate 108 may define an upper surface or a first side 114 and a lower surface or a second side 118. The diamond substrate 108 may also define a series of lateral faces, e.g., a first lateral face 110a, a second lateral face 110b, a third lateral face 110c, and a fourth lateral face 1 10d, each extending from the first side 114 to the second side 118. The first side 114 may be disposed oppositely to the second side 118. Further, the first lateral face 110a may be located oppositely to the second lateral face 1 10b, and the third lateral face 110c may be located oppositely to the fourth lateral face 110d, as well.

The diamond substrate 108 may include one or more irregular, and/or nonlinear microchannels 112. For example, the microchannels 112 may be formed in fractal forms, sinusoidal forms, grid forms, or any combination thereof. The microchannels 112 may be provided on the first side 114 of the diamond substrate 108. One or more of the microchannels 112 may also define corresponding openings (e.g., see openings 122) at the first lateral face 110a and/or the second lateral face 110b. The microchannels 112 may be engraved into the diamond substrate 108 (e.g., the microchannels 112 may extend into a body of the diamond substrate 108 from the first side 114) by one or more processes, including but not limited to additive manufacturing, chemical vapor deposition (CVD) diamond growth, and the like processes.

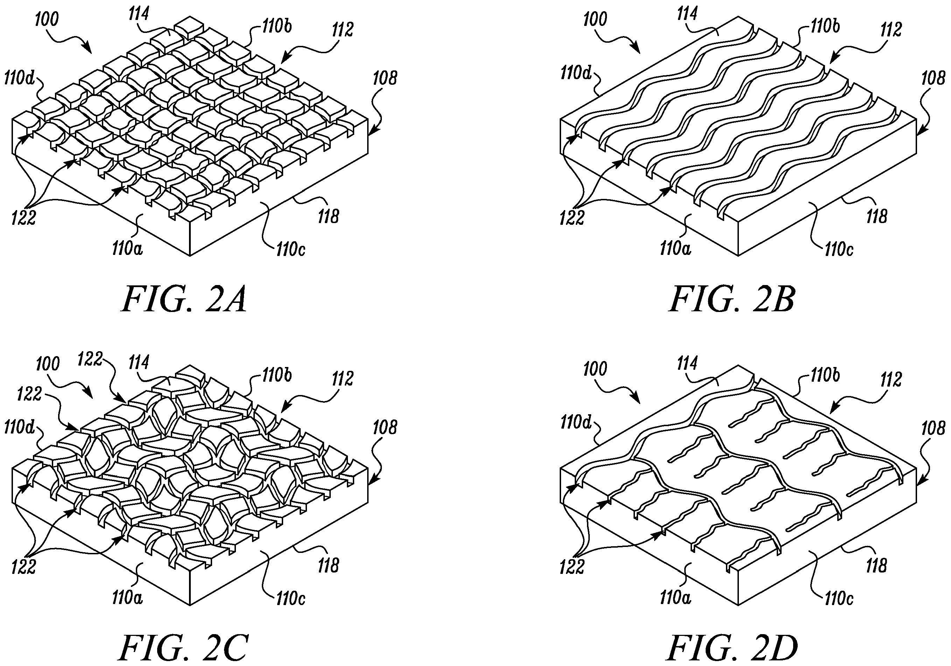

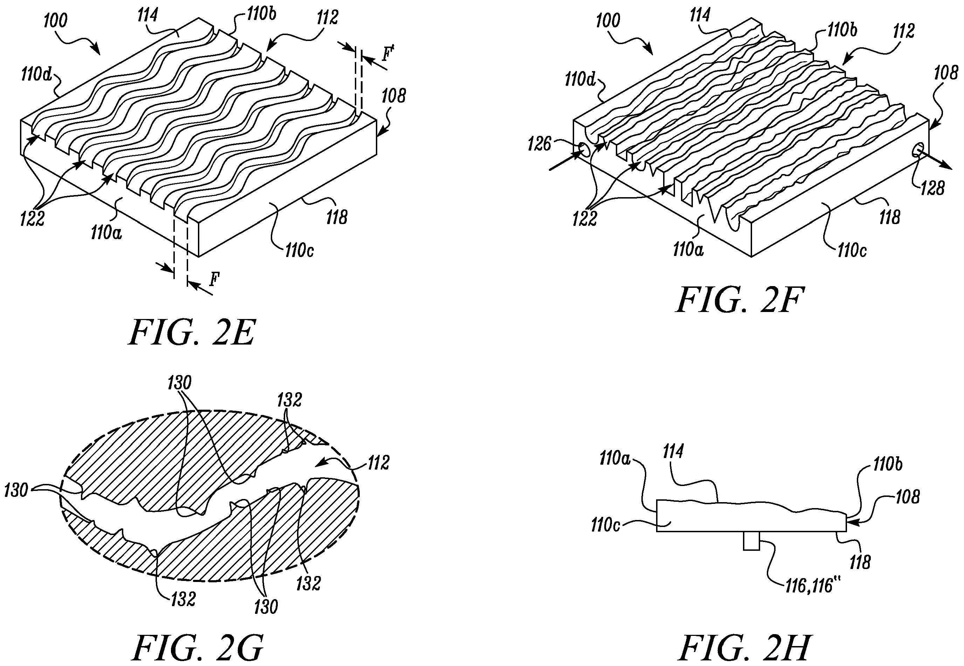

In some embodiments, the microchannels 112 include different geometries including but not limited to grid microchannels (see Fig. 2A), sinusoidal microchannels (see Fig. 2B) sinusoidal grid microchannels (see Fig. 2C), hierarchical microchannels (see Fig. 2D), tapered sinusoidal microchannels (see Fig. 2E) (the width F is greater than the width F') and the like, across their expanse or layout on the diamond substrate 108, e.g., that start from the first lateral face 110a of the diamond substrate 108 to the second lateral face 110b of the diamond substrate 108. Optionally or additionally, the microchannels 112 may include an irregular cross-section from the first lateral face 110a of the diamond substrate 108 to the second lateral face 110b of the diamond substrate 108. In some embodiments, the microchannels 112 may have varying depth and width. In some embodiments, the microchannels 112 may be different from each other. In some embodiments, the microchannels 112 may be asymmetrical. In some embodiments, the microchannels 112 may include one or more ridges, or one or more grooves formed therein to increase the surface area of the microchannels 112 (see Fig. 2G).

Further, the microchannels 112 may be laid out generally to extend from the first lateral face 110a to the second lateral face 110b - the term 'generally' used here means that the arrangement of the microchannels 112 need not be one in which the microchannels 112 are necessarily parallel to each other, as they may be non-parallel to each other, as well. Further, although profiles of the openings (e.g., the opening 122) for the microchannels 112 are shown to exemplarily include a V-shape or a U-shape, the openings 122 themselves may take irregular shapes, as well. In some embodiments, the microchannels 112 may include an irregular cross-section partly or throughout/across their expanse. In some embodiments, the microchannels 112 may have varying depth and width. In some embodiments, the microchannels 112 may be different from each other. The aforesaid features of the microchannels 112 and the diamond substrate 108 may define the geometry of the microchannels 112 and which allows thermal management for heat generating source 104 and maintaining the temperature of the heat generating source 104, in turn enabling the heat generating source 104 to function in an optimal condition. For example, the aforesaid geometry of the microchannels 112 results in an increase in an outer surface area of the diamond substrate 108, thereby allowing relatively more heat dissipation from the heat generating source 104 in turn keeping the heat generating source 104 in an optimal working temperature.

In some embodiments, the microchannels 112 may cover approximately 50% to 90% of the surface area of the diamond substrate 108 to ensure efficient heat dissipation and thermal management. The irregular and/or nonlinear microchannels 112 enable efficient heat dissipation while reducing the amount of diamond material required compared to traditional straight microchannel designs. The diamond substrate 108 may achieve enhanced thermal performance with less material usage by leveraging the increased surface area, and/or optimized microchannel density (e.g., microchannels 112 may cover approximately 50% to 90% of the surface area of the diamond substrate 108) of irregular and/or nonlinear microchannels.

In some embodiments, the diamond substrate 108 may include a varying cross-sectional area across its expanse (see Fig. 2H), depending on the heat dissipating requirements of the heat generating source 104. For example, heat dissipating requirements may include, but not limited to, a rate of removal of heat from the heat generating source 104, an amount of heat required to be lowered from the heat generating source 104 for optimal operation of the heat generating source 104. For example, the thickness of the diamond substrate 108 may be relatively more in certain regions, e.g., which may enable excess heat to be absorbed or extracted thereto, e.g., from hotspots defined by the heat generating source 104 or from locations of the heat generating source 104 which may produce relatively excessive heat. In some embodiments, the diamond substrate 108 has a thickness ranging from 50 µm (micrometer) to 10 mm. Further, a thermal conductivity of the diamond substrate 108 may lie between 800 W/mK to 2200 W/mK at 25°C. In some examples, the diamond substrate 108 may be configured to handle a heat flux that lies between 1 to 1000 W/cm2 (watts per centimeter squared). The above examples and numerals are provided for illustrative purposes, and other values may be possible. In some embodiments, the diamond substrate 108 may include an inlet 126 and an outlet 128 for circulating a fluid within the diamond substrate 108 to dissipate heat from the diamond substrate 108 (Please see FIG 2G). In some embodiments, the fluid may be circulated through the microchannels 112 to dissipate the heat from the diamond substrate 108.

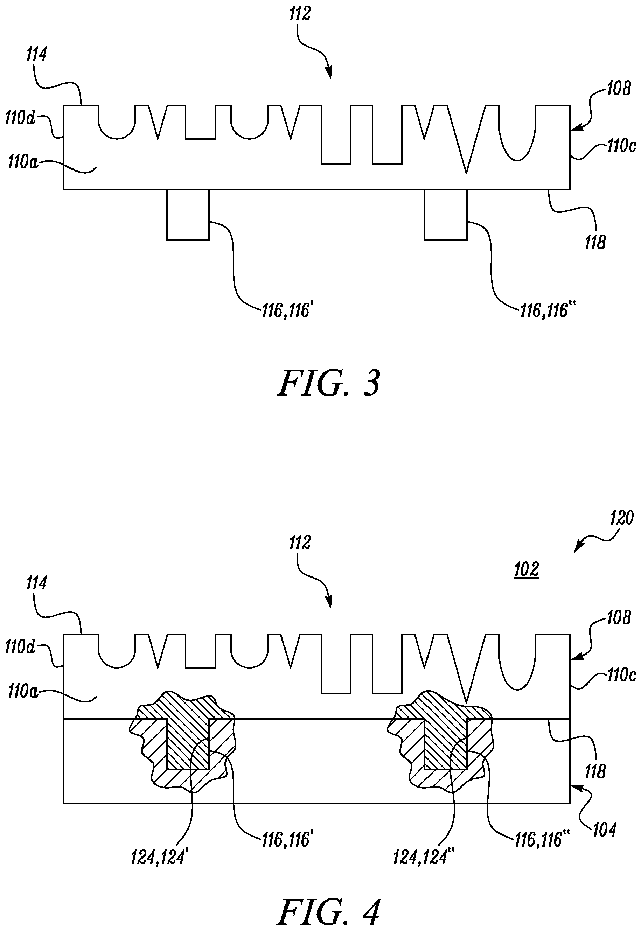

Referring to Fig. 3, the diamond substrate108 further includes one or more thermal vias 116 (e.g., see first thermal vias 116' and second thermal vias 116") (see FIG. 3 and 4). The thermal vias 116 may be provided on the second side 118 of the diamond substrate 108, opposite to the one or more microchannels 112. The one or more thermal vias 116 are configured to be connected to the heat generating source 104 for transferring a heat generated from the heat generating source 104 to the diamond substrate 108. In some embodiments, the one or more thermal vias 116 may be positioned at corresponding regions of the diamond substrate 108 where the thickness of the diamond substrate 108 is relatively high, i.e., the thermal vias 116 may be positioned at corresponding regions of the diamond substrate 108 where the chances of developing the hotspots are relatively more than other of its regions where the chances of developing the hotspots are relatively less. In some embodiments, the thermal vias 116 may include a varying cross-sectional area across its expanse, depending on the heat dissipating requirements of the heat generating source 104.

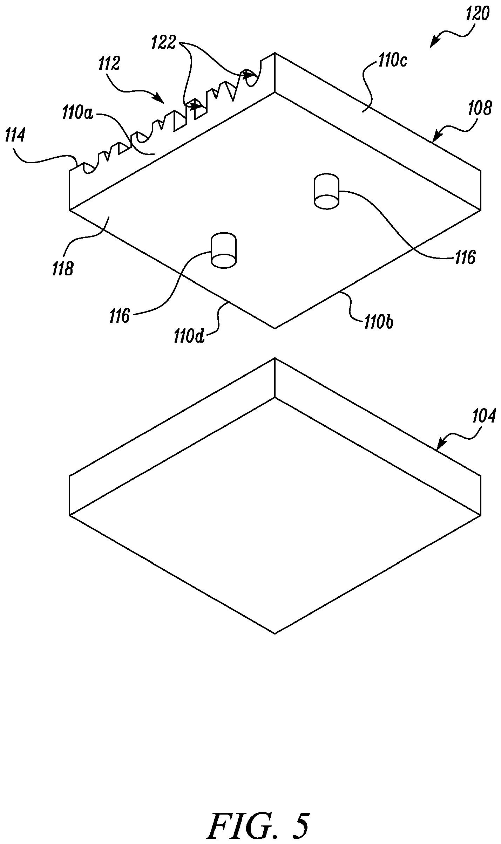

Referring to Figs. 4 and 5, an exemplary system is described. The system may correspond to any one or more of the diverse environments, described above, or subsystems thereof, and may be exemplarily referred to as a temperature-controlled system 120 for the purposes of the present disclosure. The temperature-controlled system 120 includes the heat generating source 104 and the heat spreading device 100, which may be coupled with the heat generating source 104. The heat generating source 104 may include one or more slots 124 (e.g., see first slot 124' and second slot 124") (see FIG. 4) to receive and be coupled with the thermal vias 116 of the diamond substrate 108 for allowing thermal conductivity and/or heat transfer from the heat generating source 104 to the heat spreading device 100. In some embodiments, a thermal interface material may be placed between the heat generating source 104 and the heat spreading device 100. For example, the slots 124 may be filled with a thermal interface material for increasing thermal conductivity between the slots 124 and the thermal vias 116. The slots 124 may be formed on any part of the heat generating source 104 and the position of the slots 124 on the heat generating source 104, as illustrated in any one or more of the accompanying figures, is exemplary. In some embodiments, the slots 124 may be formed in a region of the heat generating source 104 where the chances of developing the hotspots are relatively more as compared to other regions of the heat generating source 104 where the chances of developing the hotspots are relatively less. Further, in some embodiments, the slots 124 formed on the heat generating source may be formed till a partial depth of the heat generating source.

The diamond substrate 108 including one or more microchannels 112 and the thermal vias 116 may be formed or produced by deposition of a diamond layer on a wafer substrate. The wafer substrate may be made of any suitable material, including but not limited to, silicon carbide (SiC), cubic boron nitride or zinc oxide and the like. In some embodiments, the substrate may be a standard-thickness single-crystal SiC wafer or polycrystalline SiC-diamond composite wafer. The wafer substrate may be prepared by any known method such as, but not limited to, sintering, machining, consolidation, infiltration, vapor deposition, additive manufacturing, purchasing prefabricated substrates, or combinations thereof. The diamond may be deposited on the wafer substrate by a suitable method, such as but not limited to a Chemical Vapor Deposition (CVD). In some embodiments, the diamond substrate 108 may be manufactured by doping boron, hydrogen, or nitrogen, during the deposition of the diamond on the wafer substrate.

In some embodiments, the diamond substrate 108 may include different grain size distributions and grain orientations configured for enhancing the thermal conductivity of the diamond substrate 108. Particularly, the diamond substrate 108 may include different grain size distributions and grain orientations across the diamond substrate 108. Generally, grain size and grain orientation may be controlled through process parameters, such as, deposition temperature, use of dopants, and the like. In an exemplary embodiment, grain size distributions may be achieved by altering a ratio of atomic hydrogen to methane gas flow rate during a process of doping the hydrogen and methane. In some embodiments, higher methane percentage ensures the retention of diamond on already established grains rather than the formation of fresh grains leading to large singular crystals. In some embodiments, different grain orientations may be achieved by processes including, but not limited to, abrasive mechanical polishing, ion beam texturing, lithography, and the like. In some embodiments, the diamond may be a nanocrystalline diamond having a grain size of approximately 50-300 nm. In some embodiments, the diamond may be a polycrystalline diamond having a grain size of approximately 200-300 nm.

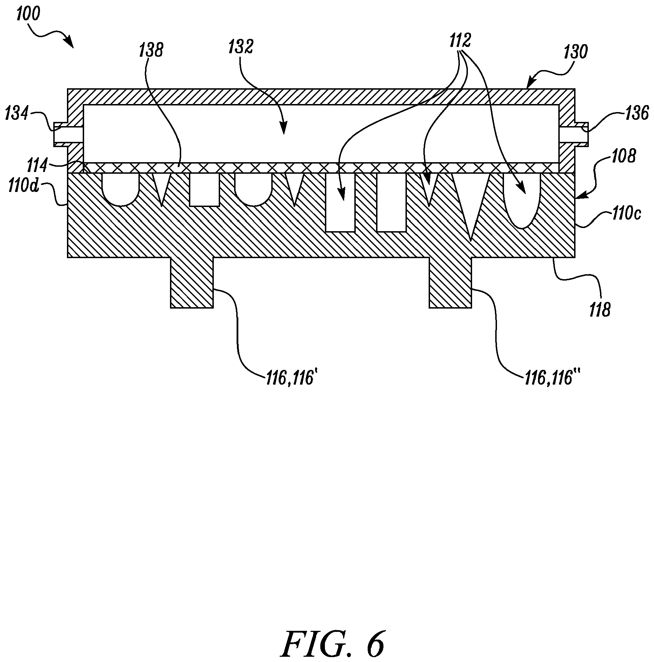

Referring to FIG. 6, the heat spreading device 100 includes a fluid housed within the microchannels 112 in a liquid state. The heat spreading device 100 further includes a lid 130 configured to hermetically seal and define a chamber 132 with the microchannels 112. The lid 130 may be made of diamond and includes an inlet 134 and outlet 136 for circulating the fluid. The fluid is configured to extract the heat from a relatively warmer region of the chamber 132, vaporize, and pass into a relatively colder region of the chamber 132 to be condensed thereof and return to the microchannels 112 in the liquid state. The fluid helps in effectively transfer heat through the phase change process. The integration of the lid 130 and the chamber 132 into the diamond substrate 108 enhances its thermal performance, leveraging the high thermal conductivity of the diamond in combination with the efficient two-phase heat transfer mechanism of the chamber 132. In some embodiments, the chamber 132 may include a wick structure 138. The wick structure 138 may be a capillary structure to allow the fluid to evaporate from the relatively warmer region of the chamber 132, vaporize, and pass into the relatively colder region of the chamber 132.

The diamond substrate may be manufactured by using a method including, but not limited to, additive manufacturing, CVD diamond growth, and the like, and said method will be exemplarily discussed below.

In some embodiments, the exemplary method of producing the diamond substrate 108 may include utilizing a computational model to determine the heat dissipation requirements for the heat generating source 104. For example, a computational model may be used to determine an amount of heat generated by the heat generating source 104 and the regions of hotspot formation in the heat generating source 104. Further, based on the amount of heat generated and the determined regions of hotspot formation in the heat generating source 104, the method includes selecting suitable substrate materials for the preparation of the wafer substrate and placing the wafer substrate in a CVD reactor. In some embodiments, the method includes directly using prefabricated wafer substrate that may be readily available. Further, the method includes depositing diamond on the wafer substrate to form the diamond substrate 108 including the microchannels 112 and the thermal vias 116. The deposition of diamond on the wafer substrate may be performed by one or more methods including, but not limited to, additive manufacturing, CVD diamond growth, and the like. For instance, the CVD reactor is filled with a mixture of gases, such as, but not limited to carbon-containing gas (e.g., methane and hydrogen). The gases may be ionized and dissociated using microwave plasma or hot filament activation technique, thereby providing a reactive environment for promoting diamond growth on the diamond. In some embodiments, the method includes depositing diamond entirely on the wafer substrate or the deposition may be restricted to certain regions based on regions of hotspot formation in the heat generating source 104. In some embodiments, the method includes the formation of the microchannels 112 by using laser etching of the diamond substrate 108. In some embodiments, the method may include using wafer bonding techniques, such as but not limited to thermocompression bonding or laser welding, to seal and bond the diamond lid to the substrate, creating the hermetically sealed vapor chamber.

In some embodiments, the method includes introducing a doping gas such as Boron, Nitrogen, or Hydrogen in the reactor with the mixture of gases. The introduction of the doping gas enhances the thermal conductivity of the diamond substrate 108. The thermal conductivity of the diamond substrate 108 is primarily influenced by factors such as grain size, grain orientation, and the presence of defects or impurities. By optimizing the CVD process parameters and minimizing the incorporation of non-diamond carbon phases or impurities, high thermal conductivity may be achieved in the deposited diamond material. In some embodiments, Nitrogen Silicon, or Germanium may also be used to increase the thermal conductivity of the diamond substrate108.

In some embodiments, the method includes the formation of the microchannels 112 and thermal vias 116 using plasma etching techniques. Plasma etching, such as Reactive Ion Etching (RIE) or Deep Reactive Ion Etching (DRIE), may be used to selectively remove diamond material and create microchannels 112 in the diamond substrate 108. By controlling one or more plasma etching parameters, such as, but not limited to, gas composition, plasma discharge pressure, plasma discharge power, and duration of the plasma discharge, etch rate and selectivity may be optimized to achieve the desired microchannel geometries and thermal via structures. In some embodiments, the method includes masking certain areas of the diamond substrate 108 from etching, thereby enabling the creation of precise microchannels 112. Plasma etching techniques are beneficial for creating deep and narrow microchannels 112 and thermal vias 116 in the diamond substrate 108. The use of plasma etching techniques for fabricating the microchannels 112 and thermal vias 116 provides flexibility in designing complex geometries and enables the creation of high-density features on the diamond substrate 108. By optimizing the plasma etching process, the desired dimensions, aspect ratios, and surface quality of the microchannels 112 and thermal vias 116 may be achieved.

In some embodiments, the method includes the formation of the microchannels 112 by using laser micromachining techniques, such as pulsed laser ablation using femtosecond or nanosecond lasers. The laser micromachining techniques offer high precision and flexibility in forming microchannel geometries on the diamond substrate 108. By precisely controlling the laser parameters, such as, but not limited to, the wavelength, pulse duration, the surface quality of the microchannels 112 may be optimized. Femtosecond lasers provide ultra-short pulse widths, which minimize thermal damage to the surrounding material of the microchannels 112 and thereby enable high-precision micromachining. The ultra-short pulses allow for the formation of microchannels with smooth surfaces and well-defined edges, reducing the need for post-processing steps. Nanosecond lasers are also commonly used for laser micromachining of diamond substrates. The laser micromachining process may be performed in a single step or multiple passes, depending on the desired depth and complexity of the microchannels 112. The method includes scanning the laser beam across the surface of the diamond substrate 108 in a predetermined pattern, to form the desired microchannel 112 geometries. After, the formation of the heat spreading device 100 having the microchannels 112, the method further includes one or more post-growth processing steps, such as, but not limited to surface polishing, laser micromachining, to provide a surface finish to the heat spreading device 100. Additionally, any excess or undesired growth of diamond on the heat spreading device 100 may be removed using known techniques such as laser cutting or etching process. The disclosed method enables the production of a monolithic thermally conductive diamond substrate 108.

In some embodiments, the diamond may be deposited by multi frequency microwave plasma-assisted chemical vapor deposition (MPCVD) method. Particularly, the diamond may be deposited on the wafer substrate in a microwave plasma reactor by combining primary 2.45GHz microwave frequency with additional higher frequency beams (e.g., 5.8GHz, 10GHz, etc.). In some embodiments, the diamond deposition may be assisted with real-time defect monitoring and automatic feedback control for depositing the diamond precisely without any defects.

In some embodiments, various other techniques may be employed to manufacture the diamond substrate 108 for the heat spreading device 100. For instance, hot filament chemical vapor deposition (HFCVD) may be used to produce polycrystalline diamond films with controlled grain sizes and orientations by dissociating the mixture of gases with a heated filament. In some embodiments, plasma jet chemical vapor deposition may be used by utilizing a high-velocity plasma jet, for enabling high diamond growth rates and efficient deposition of high-quality diamond films. In some embodiments, pulsed laser deposition (PLD), which involves ablating a diamond target with a high-power pulsed laser, may be used to produce ultra-smooth and high-purity diamond films with precise thickness control. In some embodiments, combustion flame deposition may be used by utilizing an oxyacetylene torch, to achieve high growth rates and deposit diamond films over large areas. Additionally, in some embodiments, plasma-enhanced atomic layer deposition (PEALD) may be employed to produce ultra-thin, conformal diamond films with precise thickness and composition control through a sequence of self-limiting surface reactions. The abovementioned fabrication methods offer various advantages and may be selected based on the specific requirements of the diamond heat spreader application, such as substrate size, film quality, growth rate, and cost considerations.

### Industrial Applicability

In operation, the diamond substrate is placed on the heat generating source 104 by engaging the thermal vias 116 of the diamond substrate 108 with the slots 124 of the heat generating source 104. The engagement of the diamond substrate 108 on the heat generating source 104 allows heat transfer from the heat generating source 104 to the diamond substrate 108 where the heat is transferred by the way of convection due to the microchannels 112 of the diamond substrate 108. In an exemplary embodiment, integrating the diamond substrate with a smartphone Systems-on-Chip (SoC) processor, dissipating up to 65 W/cm² heat helps in lowering the temperature of the SoC processor by up to 19°C by targeting processors' hotspots.

In some embodiments, the diamond heat spreading device 100 may be integrated with the heat generating source 104 using wafer bonding and integration techniques. Wafer bonding, such as thermos compression bonding or adhesive bonding, may be employed to join the diamond substrate 108 with materials such as, but not limited to, semiconductors, metals, or ceramics. The wafer bonding process may be optimized to achieve strong and reliable bonds with minimal thermal resistance between an interface of the heat spreading device 100 and the heat generating source 104.

In some embodiments, the diamond heat spreading device 100 may be integrated with one or more cooling technologies to provide comprehensive thermal management solutions for the heat generating source 104. For example, the heat spreading device 100 may be integrated with liquid cooling systems, where the microchannels 112 may serve as flow passages for coolants, effectively removing heat from the heat generating source 104. In some embodiments, thermoelectric cooling modules may be attached to the diamond substrate 108 to provide active cooling and precise temperature control of the heat generating source 104.

The heat spreading device 100 with microchannels 112 and thermal vias 116 may be nine times lighter and may include five times less volume compared to a conventional vapor chamber for the same performance. A comparative analysis between the performance of the heat spreading device 100 versus traditional metal heat sink solutions used in most electronics today has been provided in Table 1 below:

**Table 1: Comparative analysis between the performance of the heat spreading device 100 versus traditional metal heat sinks.**

| S. No | Type of Heat sink | Peak Temperature | Thermal Resistance | Volume |
|---|---|---|---|---|
| 1 | Aluminium Heat Sink | 112°C | 1.05 °C/W | 12 cm3 |
| 2 | Copper Heat Sink | 96°C | 0.86 °C/W | 10 cm3 |
| 3 | Heat Spreading Device 100 | 62°C | 0.31 °C/W | 2 cm3 |

The experiment was conducted on a heat source having 100W and the size of the spreader that was used to dissipate the heat was 25mm × 25mm spreader size. The velocity of air in the room was 10LFM (0.05 m/s). When an aluminium heat sink was used with the heat source the peak temperature of the heat source went up to 112°C, while the thermal resistance went up to 1.05 °C/W while the volume of the aluminium heat sink that was used in the experiment was 12 cm3. Further, when a copper heat sink was used with the same heat source the peak temperature of the heat source went up to 96°C, while the thermal resistance went up to 0.86 °C/W while the volume of the copper heat sink that was used in the experiment was 10 cm3. Furthermore, when the heat spreading device 100 was used with the same heat source the peak temperature of the heat source went only up to 62°C, while the thermal resistance only went up to 0.31 °C/W while the volume of the heat spreading device 100 was only 2 cm3.

Hence, the heat spreading device 100 had the maximum heat dissipating efficiency and the smallest size. The heat spreading device 100 had three to four times lower thermal resistance which enables three times higher heat flux handling than the conventional heat sinks. This helps keep the heat generating source 104 cooler at about 45-50°C and provides about ninety percent volume saving. Accordingly, the heat spreading device 100 is indicated to be the most efficient and cost-effective solution for dissipating heat from the heat generating source 104.

The heat spreading device 100 including the different nonlinear, and/or irregular microchannels geometries provides more heat dissipation as compared to the conventional straight microchannels. A comparative analysis between the performance of the heat spreading device 100 having microchannels 112 (sinusoidal microchannels, tapered sinusoidal microchannels, hierarchical microchannels) versus traditional straight microchannels has been provided in Table 2 below:

**Table 2: Comparative analysis between the performance of the heat spreading device 100 having nonlinear microchannels 112 versus traditional straight microchannels.**

| S. No | Type of Microchannels in Diamond Heat Spreader | Peak Temperature | Pressure Drop | Max Heat Removal |
|---|---|---|---|---|
| 1 | Straight Microchannels | 80°C | 11 kPa | 104W |
| 2 | Sinusoidal Microchannels | 75°C | 16 kPa | 112W |
| 3 | Tapered Sinusoidal Microchannels | 73°C | 12 kPa | 118W |
| 4 | Hierarchical Microchannels | 71°C | 14 kPa | 122W |

The experiment of Table 2 was conducted using computational fluid dynamics models to simulate the heat transfer and fluid flow physics for each design. Heat flux of 100W for a heat source was applied at the base as thermal load input and quantified the maximum heat dissipation capacity before reaching failure limits. The major parameters evaluated were the peak surface temperature and pressure drop across the different types of microchannels. Aspects of pressure drop helps in the quantification of heat flow losses from the diamond substrate 108. Lower temperature and pressure drop indicate better heat removal capability and flow efficiency. When straight microchannels were evaluated, the peak temperature of the heat source went up to 80°C, while the pressure drop went up to 11 kpa (Kilopascal) and the maximum heat removal was 104W. Further, when sinusoidal microchannels were evaluated, the peak temperature of the heat source went up to 75°C, while the pressure drop went up to 16 kpa and the maximum heat removal was 112W. Further, when tapered sinusoidal microchannels were evaluated, the peak temperature of the heat source went up to 73°C, while the pressure drop went up to 12 kpa and the maximum heat removal was 118W. Furthermore, when hierarchical microchannels were evaluated, the peak temperature of the heat source went up to 71°C, while the pressure drop went up to 14 kpa and the maximum heat removal was 122W.

Hence, the heat spreading device 100 with the hierarchical microchannels had the maximum heat dissipating efficiency. Further, it is evident that the maximum heat dissipation was better than the conventional straight microchannels. Accordingly, the heat spreading device 100 with nonlinear microchannels 112 was the most efficient and cost-effective solution for dissipating heat from the heat source.

Further, the sinusoidal microchannels 112 (see FIG. 2B, 2C, 2E) may have varying amplitude and wavelength. The varying amplitude and wavelength may provide better heat dissipating properties. Particularly, if the amplitude or wavelength of the sinusoidal microchannels 112 is increased, the maximum heat dissipation capacity of the sinusoidal microchannels 112 is also increased. Therefore, the amplitude or wavelength of the sinusoidal microchannels 112 is directly proportional to the heat dissipation capacity of the diamond substrate 108.

Exemplary applications of the heat spreading device 100 of the present invention will now be explained in detail. To this end, the heat spreading device 100 may be used in high power density MMICs (monolithic microwave integrated circuits) and phased arrays in satellite payloads for managing heat fluxes over 250 W/cm². The microchannels 112 on the diamond substrate 108 is essential for harnessing the exceptional thermal conductivity of diamond in satellite applications. By carefully situating the microchannels 112, electronic failures resulting from hotspots during prolonged high-power payload operations, may be effectively prevented. The heat spreading device 100 enhance heat dissipation, ensuring the reliability and longevity of electronic components in satellite systems. Further, diamond substrate 108 may be used in enclosing phased array radar semiconductor dies or satellite communication modules in aircraft to spread heat from the hotspot heat buildup during continuous use.

The heat spreading device 100 may be utilized in CMOS (Complementary Metal-Oxide-Semiconductor) image sensor modules used in portable photography devices. The heat spreading device 100 within the stacked CMOS imaging modules provides thermal conduction of the heat, thereby preventing failures arising from hotspots in portable photography devices.

The heat spreading device 100 may further be utilized in laptop and mobile device AC chargers and power adapters including gallium nitride power converters. The heat spreading device 100 under gallium nitride power converter drains their extreme heat fluxes laterally and vertically preventing localized hotspots, enabling reliable completely enclosed variable high wattage charging solutions. The heat extraction potential of diamond substrate 108 allows pulling heat effectively from switching devices during prolonged exposure to demanding power loads, avoiding thermal failure.

The incorporation of the heat spreading device 100 in wireless chargers helps in heat dissipation during rapid, high-wattage inductive charging. When placed under power transmission coils or adjacent to battery cells, the heat spreading device 100 efficiently drains extreme heat fluxes. The heat spreading device 100 enables the development of fast, reliable, and completely sealed ultra-slim charging solutions.

The heat spreading device 100 may further be utilized with high performance computing hardware including processors, GPUs, FPGA (Field Programmable Gate Array) accelerators, and memory modules. The heat spreading device 100 with high including the thermal vias 116 serves as substrates between densely packed computing components such as processors, graphics cards, AI accelerators, and memory modules. By strategically pulling heat laterally, the heat spreading device 100 prevents localized hotspots on critical logic units by laterally dissipating heat from the high performance computing hardware.

The heat spreading device 100 may further be incorporated as sheets enclosing electronics in AR/VR headsets and wearables to drain their extreme heat fluxes laterally and vertically from densely integrated components preventing localized hotspots. This enables reliable completely enclosed high powered operation without bulky extruded cooling fins or fans.

The heat spreading device 100 may be used in telecom antennas and radars with mmWave amplifier arrays exceeding 400 W/cm2 densities. The heat spreading device 100 may be attached to the mmWave power amplifier dies in 5G antennas and high resolution imaging radars to drain the extreme heat fluxes exceeding 400W/cm2 laterally to avoid hotspot failures during continuous high duty cycle Radio Frequency (RF) transmission periods.

The heat spreading device 100 including the thermal vias 116 may be directly incorporated into liquid cold plates used for cooling server rack multi-chip modules. The heat spreading device 100 uniformly distributes heat collected from thousands of densely packed ICs.

The heat spreading device 100 equipped with thermal vias 116, provides heat dissipation solution for high-power density smartphone Systems-on-Chip (SoC) processors. By establishing direct contact with the processor dies, the microchannels 112 drain lateral heat accumulation resulting from the dense transistor architecture. The heat spreading device 100 enables smartphones to maintain a reliable and indefinite turbo clock without facing shutdown risks, even when assisted by active air-cooling measures. The heat spreading device 100 also decreases size and weight of the devices including SoC processors.

The heat spreading device 100 may be used in aerospace and satellite payloads to withstand extreme temperatures. In space environments where convection cooling is limited, heat dissipation relies on radiative mechanisms or conduction to radiators. The heat spreading device 100 offers a potential solution by efficiently spreading heat laterally from electronic hot spots to external radiators. Further, diamond's properties at cryogenic temperatures may help in managing heat loads on sensitive infrared sensor arrays and superconducting electronics. Furthermore, the robustness of the diamond substrate 108 allows electronics for launch vehicles to withstand extreme acoustic noise and mechanical stresses. Diamond's high temperature withstanding capacity also allows thermal protection for electronics during the intense heating of atmospheric reentry of space vehicles at Mach 20+ velocities.

The heat spreading device 100 may be used in an electric vehicle (EV). The thermal management system in EVs including the diamond substrate 108, microchannels 112, and thermal vias 116, placed within battery cells or modules and power electronics, covering specific areas identified as hotspots, to minimize peak temperatures during charging and enhancing the overall system efficiency. Further, the heat spreading device 100 may be used in charging applications of EV, particularly, for spreading heat in AC/DC converters and rectifiers. Furthermore, the heat spreading device 100 may be incorporated into induction motor stator/rotor windings, to dissipate hotspots allowing reliable peak torque delivery without thermal failure.

The heat spreading device 100 may be used for addressing heat dissipation challenges in photovoltaic inverters and power converters. By attaching these substrates to electronics, heat can be rapidly and efficiently dissipated from thermally stressed components. In contrast to conventional inverter configurations relying on finned aluminum heat sinks, which struggle with wide temperature swings and heat densities, the use of tailored diamond substrates ensures a reliable and efficient solution for demanding operational conditions.

The heat spreading device 100 may be used with solar cells and CPV (Concentrator Photovoltaic) systems which require excess heat extraction. The heat spreading device 100 with thermal vias 116 may be incorporated as rear side heat extractor layers bonded to the receiving surface of concentrated high flux solar cells to rapidly dissipate intense heat buildup.

The heat spreading device 100 may further be used with wind turbine power generators and converters for grid integration. The diamond substrate 108 may be placed in the highest vibration zones within wind turbines, particularly near generator coil windings and magnets. The diamond substrate 108 thus facilitates the rapid dissipation of heat buildup from internal components, ensuring efficient heat management.

The heat spreading device 100 may further be utilized as a replacement for conventional electrodes in industrial electrochemical systems such as but not limited to electrolyzers, batteries, and in similar electrolysis and catalytic processes. The heat spreading device 100 as an electrode offers improved performance and longevity benefits by controlling different grain size distributions and grain orientations. Further, the diamond substrate 108 may serve as a direct replacement for conventional electrolysis electrodes, thereby providing higher efficiency, output rates, and operational lifetime. The heat spreading device 100 as the electrode provides thermal conductivity for enabling efficient heat dissipation during the electrochemical reactions, thereby preventing formation of hot spots and ensuring uniform temperature distribution across the electrode. The heat dissipation helps in preventing electrode degradation and enhancing the efficiency of the electrochemical process. For example, in a polymer electrolyte membrane (PEM) electrolyzer for hydrogen production, the diamond heat spreader as an electrode may serve as anode. The electrode helps in dissipating the heat generated during the water-splitting reaction, preventing membrane degradation and improving efficiency and durability of the PEM electrolyzer.

The heat spreading device 100 may be employed as electrodes in energy storage systems, particularly in advanced battery technologies and fuel cells. The excellent thermal conductivity and heat dissipation properties of the diamond substrate 108 may enhance the thermal management of batteries, which is crucial for their performance, safety, and longevity. The active material utilization and efficient thermal management can lead to a significant increase in the energy storage capacity per unit weight and volume. Furthermore, the enhanced ionic and electronic conductivity, combined with efficient heat dissipation, enables faster charging/discharging rates and higher power output per unit weight and volume. The efficient thermal management, reduced mechanical stresses, and improved structural stability contribute to a significantly extended cycle life, potentially doubling or tripling the number of charge/discharge cycles compared to conventional Lithium ion (Li-ion) batteries. The enhanced thermal management and improved ionic and electronic conductivity also enable faster charging times, potentially reducing the charging duration by 50 percent (%) or more. The thermal properties of diamond and the efficient heat dissipation provided by the microchannels and thermal vias allow for a broader operating temperature range, making the batteries suitable for extreme environments. The advanced thermal management and mechanical stability offered by the diamond heat spreading electrodes significantly reduce the risk of thermal runaway, overheating, and mechanical failures, enhancing the overall safety of the battery system.

In an exemplary embodiment, the heat spreading device 100 may be used as a cathode and anode for a lithium-ion battery. The cathode may be formed of Boron-doped diamond (BDD) having a doping concentration of 10²⁰ - 10²¹ atoms/cm³. The grain structure of the diamond of the cathode is nanocrystalline diamond having 5-10 nm average grain size, and the grain orientation is a textured film for increasing surface area and electrochemical activity. Further, the cathode may have sinusoidal or hierarchical microchannels having width ranging from 10-50 µm and depth ranging from 50-200 µm. Further, the diameter of the thermal vias ranges from 50-100 µm and spacing between the thermal vias ranges from 500-800 µm. Further, the cathode may may provide thermal conductivity enhancement of about 2-3 times higher than the conventional bulk diamond.

The anode may be formed of Nitrogen-doped diamond (NDD) having a doping concentration of 10¹⁹ - 10²⁰ atoms/cm³. The grain structure of the diamond of the cathode is ultrananocrystalline diamond (UNCD) with 2-5 nm average grain size, and the grain orientation is a textured film for enhanced lithium-ion intercalation/deintercalation. Further, the anode may have tapered sinusoidal microchannels having inlet width ranging from 5-20 µm and outlet width ranging from 30-50 µm, and depth ranging from 30-100 µm. Further, the diameter of the thermal vias ranges from 30-80 µm and spacing depending upon the chances of formation of the hotspots.

A comparative analysis between the performance of the heat spreading device 100 as electrodes versus traditional graphite and diamond electrodes has been provided in Table 3 below:

**Table 3: A comparative analysis between the performance of the heat spreading device 100 as electrodes versus traditional graphite and diamond electrodes.**

| S. No | Parameters | Graphite | Diamond Substrate | Heat spreading device 100 |
|---|---|---|---|---|
| 1 | Cell Potential (V) | 3.64 | 3.83 | 3.92 |
| 2 | Energy Density (Wh/L) | 550 | 625 | 695 |
| 3 | Max Temp Rise (°C) | 12 | 6 | 3 |
| 4 | Heat Gen. Rate (W/m^3) | 2.1×10⁶ | 1.4×10⁶ | 0.9×10⁶ |
| 5 | Cycle Life (cycles) | 800 | 1800 | 3000 |

As it is very evident from the above table that the heat spreading device 100 as the electrodes for the lithium-ion battery provides the highest cell potential (V), while the temperature rise was the least in the heat spreading device 100. The number of cycles of the lithium-ion battery was also increased when the heat spreading device 100 was used as the electrodes, and the heat generation rate was the least in case of having the heat spreading device 100 as the electrodes.

In an exemplary embodiment, the heat spreading device 100 may be used as a cathode and anode for use in industrial electrolyzer systems. The cathode may be formed of Boron-doped diamond (BDD) having a doping concentration of 5×10²⁰ - 1×10²¹ atoms/cm³. The grain structure of the diamond of the cathode is nanocrystalline diamond having 10-20 nm average grain size, and the grain orientation is a textured film. Further, the cathode may have hierarchical microchannels having width ranging from 20-40 µm and depth ranging from 100-150 µm for primary microchannels and width ranging from 5-10 µm and depth ranging from 30-50 µm for secondary microchannels. Further, the diameter of the thermal vias ranges from 75-100 µm and spacing between the thermal vias ranges from 500-800 µm.

The anode may be formed of Nitrogen-doped diamond (NDD) having a doping concentration of 1×10¹⁹ - 5×10¹⁹ atoms/cm³. The grain structure of the diamond of the cathode is ultrananocrystalline diamond (UNCD) with 3-8 nm average grain size, and the grain orientation is a textured film. Further, the anode may have tapered sinusoidal microchannels having inlet width ranging from 10-20 µm and outlet width ranging from 30-50 µm, and depth ranging from 75-125 µm. Further, the diameter of the thermal vias ranges from 50-75 µm and spacing depending upon the chances of formation of the hotspots. The heat spreading device 100 as the electrodes in industrial electrolyzer system may provide enhanced cell voltage of 1.63V vs. 1.92V for conventional electrodes. Similarly, the current density was 0.85 A/cm^2 which was approximately 112% higher than conventional electrodes. The Hydrogen production rate was about 0.038 L/min which was approximately 111% higher than conventional electrodes. Further, the Faradaic efficiency was about 96% as compared to 87% for the conventional electrodes. `Faraday efficiency' may be defined as the efficiency with which charge is transferred in a system facilitating an electrochemical reaction. The maximum electrode temperature went only up to 79°C vs. 97°C for conventional electrodes. The electrolyte temperature gradient of the heat spreading device 100 as the electrode went only up to 5°C as compared to 15°C for conventional electrodes.

The diamond heat spreading device 100 also has the potential for integration with electronic packaging technologies, such as 3D (three dimensional) chip stacking and heterogeneous integration. This is because the diamond heat spreading device 100, with its high thermal conductivity and ability to efficiently spread heat, can be integrated into a 3D chip stack to provide effective thermal management for the chip stack. For example, by incorporating the diamond heat spreading device 100 between any stacked layers, the thermal challenges (e.g., effective heat dissipation) of such stacking, e.g., chip stacking, can be addressed.

Similarly, in heterogeneous integration, where multiple disparate components, such as processors, memory, and sensors, are integrated onto a single package, the diamond heat spreading device 100 can manage the diverse thermal requirements of these components. To this end, the diamond heat spreading device 100 can be selectively integrated with any component, such as high-performance processors or power management ICs (Integrated Chips), of the package that generate significant heat, in turn enhancing the thermal performance of the heterogeneous package. In other words, the ability of the diamond heat spreading device 100 to efficiently dissipate heat and maintain a uniform temperature distribution across the package enables the integration of thermally sensitive components, unlocking possibilities for highly integrated, multifunctional electronic systems.

In some embodiments, the diamond heat spreading device 100 is particularly well-suited for use in artificial intelligence (AI) applications and data centers. As AI workloads become increasingly complex and demanding, the power densities of AI hardware, such as GPUs and dedicated AI accelerators, continue to rise. This leads to significant cooling challenges and the need for advanced thermal management solutions. The diamond heat spreading device 100 including exceptional thermal conductivity, combined with its innovative microchannel design and thermal vias, makes it an ideal choice for dissipating heat from high-power AI components. By efficiently spreading heat and reducing hot spots, the diamond heat spreading device 100 enables AI hardware to operate at optimal performance levels while maintaining reliability and energy efficiency. The superior thermal management capabilities of the diamond heat spreader make it a valuable solution for the growing thermal challenges in AI data centers and high-performance computing environments. The diamond heat spreader offers significant advantages over conventional ceramic heat spreaders in AI data center applications. With its exceptional thermal conductivity of 1800 W/mK, the diamond heat spreader efficiently dissipates heat, resulting in a 30°C lower maximum GPU temperature and a 30°C lower average surface temperature compared to aluminum nitride (AlN) ceramic heat spreaders. The unique design features of the diamond heat spreading device 100, including sinusoidal microchannels and thermal vias, enable a 10°C smaller temperature gradient and a 2.3 times higher heat flux, ensuring optimal thermal performance and reduced hot spots. Moreover, the unparalleled durability and reusability of diamonds minimize the need for frequent replacements, reducing waste and environmental impact. The superior thermal performance of the diamond heat spreader also leads to energy savings in AI data center cooling systems, making it a cost-effective and eco-friendly solution in the long run.

In addition to the applications mentioned above, the diamond heat spreader technology may also be used in various other industries, such as, but not limited to, 5G and telecommunications infrastructure (for cooling high-power RF components and ensuring reliable operation of 5G networks), medical devices and imaging equipment (for dissipating heat from MRI machines, CT scanners, and X-ray systems), industrial laser systems (for cooling laser diodes and optics, enabling higher power outputs and improved process stability), cryptocurrency mining hardware (for cooling ASICs (Application Specific Integrated Circuit) and GPUs), power electronics and EV charging infrastructure (for cooling converters, inverters, and rectifiers, ensuring safe and efficient charging of electric vehicles).

It will be apparent to those skilled in the art that various modifications and variations can be made to the method and/or system of the present disclosure without departing from the scope of the disclosure. Other embodiments will be apparent to those skilled in the art from consideration of the specification and practice of the method and/or system disclosed herein. It is intended that the specification and examples be considered as exemplary only, with a true scope of the disclosure being indicated by the following claims and their equivalent.

## Claims

1. A heat spreading device (100) comprising:
a diamond substrate (108) including one or more irregular and/or nonlinear microchannels (112) provided on a first side (114) of the diamond substrate (108) and one or more thermal vias (116) provided on a second side (118) of the diamond substrate (108) opposite to the one or more irregular and/or nonlinear microchannels (112);
wherein the one or more thermal vias (116) are configured to be connected to one or more heat generating sources (104) for transferring a heat generated from the one or more heat generating sources (104) to the diamond substrate (108).

2. The heat spreading device (100) of claim 1, wherein the diamond substrate (108) is a monolithic structure produced by an additive manufacturing process or a chemical vapor deposition (CVD) process.

3. The heat spreading device (100) of claim 1, wherein the diamond substrate (108) is produced from a single crystalline or polycrystalline diamond.

4. The heat spreading device (100) of claim 1, wherein the diamond substrate (108) is produced by doping diamond with Boron, Hydrogen and/or Nitrogen.

5. The heat spreading device (100) of claim 1, wherein the diamond substrate (108) includes different grain size distributions and grain orientations configured for enhancing thermal conductivity.

6. The heat spreading device (100) of claim 1, wherein the diamond substrate (108) includes a varying cross-sectional area across its expanse, and wherein the one or more thermal vias (116) include a varying cross-sectional area across its expanse.

7. The heat spreading device (100) of claim 1, wherein a thermal conductivity of the diamond substrate (108) is between 800 W/mK to 2200 W/mK at 25°C and wherein a thickness of the diamond substrate (108) is between 50 µm - 10 mm.

8. The heat spreading device (100) of claim 1, wherein the one or more irregular and/or nonlinear microchannels (112) are different from each other, and wherein the irregular and/or nonlinear microchannels (112) may be in one or more forms, the one or more forms comprising a fractal forms, sinusoidal forms, grid forms or any combination thereof, and wherein the one or more irregular and/or nonlinear microchannels (112) covers 50% to 90% of surface area of the diamond substrate (108).

9. The heat spreading device (100) of claim 1, wherein the one or more heat generating sources (104) is selected from a group consisting of: electronic devices, integrated circuit dies, inductive charging coils, power amplifiers, laser diodes, high intensity discharge lamps, combustion heat exchangers, vacuum electrode assemblies, turbine blades, steam generator components, mirror facets of solar concentrators, pharmaceutical reactors, microfluidic lab-on-chip devices, resistive memory elements, quantum computing qubits, biological imaging lasers, high speed reciprocating equipment, electrodes of a battery, a battery, an industrial electrolyzer system, or microprocessors.

10. The heat spreading device (100) of claim 1, wherein the diamond substrate (108) is configured to handle a heat flux between 1 to 1000 W/cm2.

11. The heat spreading device (100) of claim 1 further including:
a fluid housed within the one or more irregular and/or nonlinear microchannels (112) in a liquid state; and
a lid (130) to hermetically seal and define a chamber (132) with the one or more irregular and/or nonlinear microchannels (112), wherein the fluid is configured to extract the heat from a relatively warmer region of the chamber (132), vaporize, and pass into a relatively colder region of the chamber (132) to be condensed thereof and return to the one or more irregular and/or nonlinear microchannels (112) in the liquid state.

12. A temperature-controlled system (120) comprising:
one or more heat generating sources (104);
one or more heat spreading devices (100) coupled with the one or more heat generating sources (104);
wherein the one or more heat spreading devices (100) comprise:
a diamond substrate (108) including one or more irregular and/or nonlinear microchannels (112) provided on a first side (114) of the diamond substrate (108) and one or more thermal vias (116) provided on a second side (118) of the diamond substrate (108) opposite to the one or more irregular and/or nonlinear microchannels (112);
wherein the one or more thermal vias (116) are configured to be connected to one or more heat generating sources (104) for transferring a heat generated from the one or more heat generating sources (104) to the diamond substrate (108).

13. The temperature-controlled system (120) of claim 12, wherein the diamond substrate (108) is a monolithic structure produced by an additive manufacturing process or a chemical vapor deposition (CVD) process.

14. The temperature-controlled system (120) of claim 12, wherein the diamond substrate (108) is produced from a single crystalline or polycrystalline diamond.

15. The temperature-controlled system (120) of claim 12, wherein the diamond substrate (108) is produced by doping diamond with Boron, Hydrogen and/or Nitrogen.

16. The temperature-controlled system (120) of claim 12, wherein the diamond substrate (108) includes different grain size distribution and grain orientation configured for enhancing thermal conductivity.

17. The temperature-controlled system (120) of claim 12, wherein the diamond substrate (108) includes a varying cross-sectional area across its expanse, and wherein the one or more thermal vias (116) include a varying cross-sectional area across its expanse.

18. The temperature-controlled system (120) of claim 12, wherein a thermal conductivity of the diamond substrate (108) is between 800 W/mK to 2200 W/mK at 25°C and a thickness of the diamond substrate (108) is between 50 µm - 10 mm.

19. The temperature-controlled system (120) of claim 12, wherein the one or more irregular and/or nonlinear microchannels (112) are different from each other and wherein the irregular and/or nonlinear microchannels (112) may be in one or more forms, the one or more forms comprising a fractal forms, sinusoidal forms, grid forms or any combination thereof, and wherein the one or more irregular and/or nonlinear microchannels (112) covers 50% to 90% of surface area of the diamond substrate (108).

20. The temperature-controlled system (120) of claim 12, wherein the one or more heat generating sources (104) is selected from a group consisting of but not limited to: electronic devices, integrated circuit dies, inductive charging coils, power amplifiers, laser diodes, high intensity discharge lamps, combustion heat exchangers, vacuum electrode assemblies, turbine blades, steam generator components, mirror facets of solar concentrators, pharmaceutical reactors, microfluidic lab-on-chip devices, resistive memory elements, quantum computing qubits, biological imaging lasers, high speed reciprocating equipment, electrodes of a battery, a battery, an industrial electrolyzer system, or microprocessors.

21. The temperature-controlled system (120) of claim 12, wherein the diamond substrate (108) is configured to handle a heat flux between 1 to 1000 W/cm2.

22. The temperature-controlled system of claim 12 further including:
a fluid housed within the one or more irregular and/or nonlinear microchannels (112) in a liquid state; and
a lid (130) to hermetically seal and define a chamber (132) with the one or more irregular and/or nonlinear microchannels (112), wherein the fluid is configured to extract the heat from a relatively warmer region of the chamber (132), vaporize, and pass into a relatively colder region of the chamber (132) to be condensed thereof and return to the one or more irregular and/or nonlinear microchannels (112) in the liquid state.
